Europäisches Patentamt

European Patent Office

Office européen des brevets

(11) Publication number: **0 653 684 A1**

# EUROPEAN PATENT APPLICATION

(21) Application number: **94202990.1**

(22) Date of filing: **14.10.94**

(51) Int. Cl.⁶: **G03F 7/34**, G03F 7/11

(30) Priority: **16.11.93 EP 93203188**

(43) Date of publication of application:
**17.05.95 Bulletin 95/20**

(84) Designated Contracting States:
**BE DE FR GB NL**

(71) Applicant: **AGFA-GEVAERT naamloze vennootschap**
Septestraat 27
B-2640 Mortsel (BE)

(72) Inventor: **Vermeersch, Johan**
c/o Agfa-Gevaert N.V.,
DIE 3800,
Septestraat 27
B-2640 Mortsel (BE)
Inventor: **Daems, Eddie**
c/o Agfa-Gevaert N.V.,
DIE 3800,
Septestraat 27
B-2640 Mortsel (BE)
Inventor: **Van Damme, Marc**
c/o Agfa-Gevaert N.V.,
DIE 3800,
Septestraat 27
B-2640 Mortsel (BE)
Inventor: **Leenders, Luc**
c/o Agfa-Gevaert N.V.,
DIE 3800,
Septestraat 27
B-2640 Mortsel (BE)
Inventor: **Nouwen, Tom**
c/o Agfa-Gevaert N.V.,
DIE 3800,
Septestraat 27
B-2640 Mortsel (BE)
Inventor: **Uytterhoeven, Herman**
c/o Agfa-Gevaert N.V.,
DIE 3800,
Septestraat 27
B-2640 Mortsel (BE)
Inventor: **Hendrickx, Peter**
c/o Agfa-Gevaert N.V.,
DIE 3800,
Septestraat 27
B-2640 Mortsel (BE)

(54) **Imaging element comprising a photopolymerizable composition and methods for producing lithographic plates therewith.**

(57) The present invention provides an imaging element comprising on a hydrophilic base a hydrophobic photopolymerizable composition capable of being irradiated with actinic light through the support and/or through the front and comprising at least one monomer and at least one polymeric binder, characterized in that said imaging element comprises on top of said photopolymerizable composition one or more protective layers selected from the group consisting of:
- a transfer layer which is capable of adhering to the underlying contiguous layer and to a receptor layer, said transfer layer, when being a thermoadhesive layer having a glas transition temperature $T_g$ between 10 °C and 100 °C as measured with the 1090 THERMOANALYZER of Du Pont Co. and a melt viscosity of more than 3000 Poise measured at 120 °C with the VISCOELASTIC MELT TESTER of Rheometrics Co, Surrey, UK.,
- and a receptor layer which is capable of adhering to the underlying contiguous layer and which is upperlying said transfer layer(s) if any is present, said receptor layer, when being the only protective layer in said imaging element being paper or a poly-Alpha-olefin coated paper.

EP 0 653 684 A1

1. Field of the invention.

The present invention relates to an imaging element comprising a photopolymerisable composition and to a method for the formation of lithographic printing plates.

2. Background of the invention.

The use of photosensitive imaging elements comprising photopolymerizable compositions for the production of images by information-wise exposure thereof to actinic radiation is well known. Several methods for forming images using photopolymerizable compositions are known. All these methods are based on the principle of introducing a differentiation in properties between the exposed and non-exposed parts of the photopolymerizable composition e.g. a difference in solubility, adhesion, conductivity, refractive index, tackiness, permeability, diffusibility of incorporated substances e.g. dyes etc.. The thus produced differences may be subsequently employed in a developing step to produce a visible image and/or master for printing e.g. a lithographic or electrostatic printing master.

A difference in solubility between the exposed and non-exposed parts of the photopolymerizable composition is often used for the production of lithographic printing plates where a hydrophilic base is coated with the photopolymerizable composition, subsequently exposed and developed using a solvent to remove the non-exposed or insufficiently exposed parts. Such a process is for example described in "Unconventional imaging processes" by E. Brinckman, G. Delzenne, A. Foot and J. Willems, Focal Press London-New York, first edition 1978, pages 33 to 39.

The use of the difference in tackiness to obtain an image is described in e.g. US-P 3,060,024, 3,085,488 and 3,649,268. According to the method disclosed in these US patents the image-wise exposed photopolymerizable composition looses its tackiness in the exposed parts while the non-exposed parts keep their tackiness. The non-exposed parts can therefore be colored with dry dye pigments to make the image visible.

According to a method disclosed in US-P 3,060,023 the adhesion of the photopolymerizable composition is modified upon image-wise exposure. After image-wise exposure the non-exposed parts will stick or adhere, during a step of overall heating, to a receptor sheet thus allowing the transfer of the non-exposed parts to the receptor sheet.

According to a method disclosed in US-P 3,060,023 the adhesion of the photopolymerizable composition is modified upon image-wise exposure. After image-wise exposure the non-exposed parts will stick or adhere, during a step of overall heating, to a receptor sheet thus allowing the transfer of the non-exposed parts to the receptor sheet.

US-P 3,060,026 discloses a process for image production which comprises (i) exposing a photopolymerizable element having a stick temperature above 40°C and below 220°C imagewise, so as to increase the stick temperature in the exposed areas, (ii) bringing the surface of the exposed photopolymerizable element into contact with an image-receptor element, (iii) heating at least one of the contacting surfaces to a temperature intermediate between the stick temperatures of the exposed and underexposed areas and (iv) transferring the underexposed image areas to the receptor element, said photopolymerizable element being covered during the exposure with a removable transparent cover layer and removing said cover layer prior to the transfer of the underexposed image areas to the receptor element.

US-P 3,342,593 discloses a process for image production which comprises (i) exposing a photopolymerizable element having a stick temperature above 40°C and below 220°C imagewise, said photopolymerizable element having a support bearing a photopolymerizable layer comprising (1) an compound containing at least one terminal ethylenic group, (2) an initiator, (ii) preheating said exposed element to a temperature above 35°C but below the stick temperature of the underexposed areas , (iii) heating said exposed element to a temperature above said stick temperature and (iv) transferring the unexposed polymer to a receptor.

US-P 3,622,320 discloses imaging elements containing photocrosslinkable polyesters for use in heat transfer processes for making images or for making a lithographic printing plate.

GB-P 1,530,410 discloses a light-sensitive planographic printing plate material comprising (a) a support the surface of which is anodically oxidized aluminium or aluminium alloy, (b) a layer consisting of a hydrophillic organic polymer, (c) at least one layer of a light-sensitive composition and (d) a transparent cover film, arranged on said oxidized surface of the support in this order, the light-sensitive composition having the property that after the material has been imagewise exposed to light there is a difference in the adhesivity to polymer layer (b) and said transparent cover film between exposed areas and unexposed

2

areas of said light-sensitive composition (c), the areas of greater adhesivity to said transparent cover film of said light-sensitive composition layer are peeled off together with said transparent cover film and the areas of greater adhesivity to said polymer layer (b) are left thereon, whereby an image is formed supported on the support.

EP-A 40,424 discloses a negative-working dry peel apart photopolymerizable element consisting essentially of a support, a cover sheet and therebetween a layer of photopolymerizable composition consisting essentially of (1) at least two halogen-free polymeric organic binders, (2) an initiator system, and (3) a monomer having at least one terminal ethylenic group, the monomer being present in a quantity in excess of the absorptive capacity of the binders for the monomer so that a thin layer of substantially free monomer is present at the interface between the photopolymerizable layer and the cover sheet, the adhesion of the polymerizable layer to the cover sheet being greater before polymerization than it is to the support.

EP-A 568,744 discloses a method for producing a lithographic printing plate which comprises: (i) providing an uncoated lithographic substrate, (ii) coating a photosensitive layer on one side of the lithographic substrate, (iii) providing a flexible substrate, (iv) coating an adhesive layer directly on the flexible substrate, (v) laminating the coated lithographic substrate to the coated flexible substrate, (vi) imagewise exposing the laminated element of (v) to radiation to which the photosensitive layer is sensitive and (vii) peeling off the flexible substrate along with the nonimage areas of the photosensitive layer.

As illustrated above photopolymerization can be used in a variety of methods to reproduce images. Among these methods several are using dry-developing steps e.g. heating for producing the image which is convenient and offers an ecological advantage. However the quality of the image obtainable with photopolymerizable compositions using a dry-developing step, e.g. a thermal transfer step, is mediocre due to pinholes in the printing areas and imaging spots (staining) in the non-printing areas. This is caused by delamination faults resulting from the inclusion of dust particles between the layer containing the photopolymerizable composition and the base layer and/or the receptor layer before and/or during the exposure and the development of the imaging element, resulting in incomplete patternwise transfer of the photosensitive layer upon heating to the receptor sheet. Furthermore an effective pattern-wise removal by transfer of the photosensitive layer upon heating to the receptor sheet during the development of the image requires the use of a high quality, costly receptor layer, e.g. polyester film or smooth paper. The possibility of using cheaper receptor layers e.g. coarse paper, to remove pattern-wise areas of the photosensitive layer would be appreciated.

3. Summary of the invention.

It is an object of the present invention to provide an imaging element comprising a photopolymerizable composition said imaging element being developable after exposure by using heat and/or pressure and providing a lithographic printing plate of a high quality upon pattern-wise removal of said photopolymerizable composition by means of a receptor element, even when applying cheap receptor layers.

It is another object of the present invention to provide a method for obtaining a lithographic printing plate of a high quality using said imaging element.

Further objects of the present invention will become clear from the description hereinafter.

According to the present invention an imaging element is provided comprising on a hydrophilic base a hydrophobic photopolymerizable composition capable of being irradiated with actinic light through the support and/or through the front and comprising at least one monomer and at least one polymeric binder, characterized in that said imaging element comprises on top of said photopolymerizable composition one or more protective layers selected from the group consisting of:

- a transfer layer which is capable of adhering to the underlying-contiguous layer and to a receptor layer, said transfer layer, when being a thermoadhesive layer having a glas transition temperature $T_g$ between 10 °C and 100 °C as measured with the 1090 THERMOANALYZER of Du Pont Co. and a melt viscosity of more than 3000 Poise measured at 120 °C with the VISCOELASTIC MELT TESTER of Rheometrics Co, Surrey, UK.,

- and a receptor layer which is capable of adhering to the underlying contiguous layer and which is upperlying said transfer layer(s) if any is present, said receptor layer, when being the only protective layer in said imaging element being paper or a poly-Alpha-olefin coated paper.

According to the present invention there is also provided a method for obtaining a lithographic printing plate comprising the steps of:

(a) image-wise or information-wise exposing an imaging element according to the present invention

3

(b) laminating the upper non-receptor layer of said imaging element to a receptor layer before or after said exposure and

(c) peeling away the receptor element, comprising said receptor layer from the hydrophilic base thus transferring said hydrophobic photopolymerizable composition pattern-wise to the receptor element.

4. Detailed description of the invention.

It has been found that lithographic printing plates of high quality can be obtained according to the method of the present invention using an imaging element comprising on a hydrophilic base (i) a hydrophobic photopolymerizable composition and (ii) one or more protective layers. More precisely it has been found that said printing plates are substantially free of staining in the non-printing areas. When the protective layer used in the imaging element according to the present invention is left out the obtained printing plate is unsuitable for use due to a high degree of staining.

The hydrophilic base of the imaging element according to the present invention is a hydrophilic base that is stable at the processing conditions.

Said hydrophilic base may be a hydrophilic metallic support e.g. an aluminium support.

The aluminum support of the imaging element for use in accordance with the present invention can be made of pure aluminum or of an aluminum alloy, the aluminum content of which is at least 95%. The thickness of the support usually ranges from about 0.13 to about 0.50 mm.

The preparation of aluminum or aluminum alloy foils for lithographic offset printing comprises the following steps : graining, anodizing, and optionally sealing of the foil.

Graining and anodization of the foil are necessary to obtain a lithographic printing plate that allows to produce high-quality prints in accordance with the present invention. Sealing is not necessary but may still improve the printing results. Preferably the aluminum foil has a roughness with a CLA value between 0.2 and 1.5 $\mu$m, an anodization layer with a thickness between 0.4 and 2.0 $\mu$m and is sealed with an aqueous bicarbonate solution.

According to the present invention the roughening of the aluminum foil can be performed according to the methods well known in the prior art. The surface of the aluminum substrate can be roughened either by mechanical, chemical or electrochemical graining or by a combination of these to obtain a satisfactory adhesiveness of a silver halide emulsion layer to the aluminum support and to provide a good water retention property to the areas that will form the non-printing areas on the plate surface.

The electrochemical graining process is preferred because it can form a uniform surface roughness having a large average surface area with a very fine and even grain which is commonly desired when used for lithographic printing plates.

Electrochemical graining can be conducted in a hydrochloric and/or nitric acid containing electrolyte solution using an alternating or direct current. Other aqueous solutions that can be used in the electrochemical graining are e.g. acids like HCl, $HNO_3$, $H_2SO_2$, $H_3PO_4$, that if desired, contain additionally one or more corrosion inhibitors such as $Al(NO_3)_3$, $AlCl_3$, boric acid, chromic acid, sulfates, chlorides, nitrates, monoamines, diamines, aldehydes, phosphates, $H_2O_2$, etc. ...

Electrochemical graining in connection with the present invention can be performed using single-phase and three-phase alternating current. The voltage applied to the aluminum plate is preferably 10-35 V. A current density of 3-150 Amp/dm$^2$ is employed for 5-240 seconds. The temperature of the electrolytic graining solution may vary from 5-50°C. Electrochemical graining is carried out preferably with an alternating current from 10 Hz to 300 Hz.

The roughening is preferably-preceded by a degreasing treatment mainly for removing fetty substances from the surface of the aluminum foil.

Therefore the aluminum foil may be subjected to a degreasing treatment with a surfactant and/or an aqueous alkaline solution.

Preferably roughening is followed by a chemical etching step using an aqueous solution containing an acid. The chemical etching is preferably carried out at a temperature of at least 30°C more preferably at least 40°C and most preferably at least 50°C.

Suitable acids for use in the aqueous etch solution are preferably inorganic acids and most preferably strong acids. The total amount of acid in the aqueous etch solution is preferably at least 150g/l. The duration of chemical etching is preferably between 3s and 5min.

After roughening and optional chemical etching the aluminum foil is anodized which may be carried out as follows.

An electric current is passed through the grained aluminum foil immersed as an anode in a solution containing sulfuric acid, phosphoric acid, oxalic acid, chromic acid or organic acids such as sulfamic, benzosulfonic acid, etc. or mixtures thereof. An electrolyte concentration from 1 to 70 % by weight can be used within a temperature range from 0-70 °C. The anodic current density may vary from 1-50 A/dm$^2$ and a voltage within the range 1-100 V to obtain an anodized film weight of 1-8 g/m$^2$ Al$_2$O$_3$.H$_2$O. The anodized aluminum foil may subsequently be rinsed with demineralised water within a temperature range of 10-80 °C.

After the anodizing step sealing may be applied to the anodic surface. Sealing of the pores of the aluminum oxide layer formed by anodization is a technique known to those skilled in the art of aluminum anodization. This technique has been described in e.g. the "Belgisch-Nederlands tijdschrift voor Oppervlaktetechnieken van materialen", 24ste jaargang/januari 1980, under the title "Sealing-kwaliteit en sealing-controle van geanodiseerd Aluminum". Different types of sealing of the porous anodized aluminum surface exist.

Preferably, said sealing is performed by treating a grained and anodized aluminum support with an aqueous solution containing a bicarbonate as disclosed in EP-A 567178, which therefor is incorporated herein by reference.

Preferably each of the above described steps is separated by a rinsing step to avoid contamination of the liquid used in a particular step with that of the preceding step.

To promote the image sharpness and, as a consequence thereof, the sharpness of the final printed copy, the anodization layer may be coloured in the mass with an antihalation dye or pigment e.g. as described in JA-Pu-58-14,797.

More preferably, said hydrophilic base is a hydrophilic base comprising a hardened hydrophilic layer, containing a hydrophilic binder and a hardening agent coated on a flexible support.

Such hydrophilic binders are disclosed in e.g. EP-A 450,199, which therefor is incorporated herein by reference. Preferred hardened hydrophilic layers comprise partially modified dextrans or pullulan hardened with an aldehyde as disclosed in e.g. EP-A 514,990 which therefor is incorporated herein by reference. More preferred hydrophilic layers are layers of polyvinyl alcohol hardened with a tetraalkyl orthosilicate and preferably containing SiO$_2$ and/or TiO$_2$ wherein the weight ratio between said polyvinylalcohol and said tetraalkyl orthosilicate is between 0.5 and 5 as disclosed in e.g. GB-P 1,419,512, FR-P 2,300,354, US-P-3,971,660, US-P 4,284,705, EP-A 405,016 and EP-A 450,199 which therefor are incorporated herein by reference.

A particularly suitable hydrophilic layer is a layer of polyvinyl alcohol hardened with tetramethylor-thosilicate or tetraethylorthosilicate containing TiO$_2$, wherein the weight ratio between said polyvinylalcohol and said tetramethylorthosilicate or tetraethylorthosilicate is between 0.8 and 2 and wherein the weight ratio between said polyvinylalcohol and said titaniumdioxide is preferably not higher than 1.

The flexible supports may be opaque or transparent, e.g. a paper support or a resin support. When a paper support is used preference is given to one coated at one or both sides with an Alpha-olefin polymer, e.g. a polyethylene layer which optionally contains an anti-halation dye or pigment. Preferably an organic resin support is used e.g. cellulose esters such as cellulose acetate, cellulose propionate and cellulose butyrate; polyesters such as poly(ethylene terephthalate); polyvinyl acetals, polystyrene, polycarbonate; polyvinylchloride or poly-Alpha-olefins such as polyethylene or polypropylene.

One or more subbing layers may be coated between the flexible hydrophobic support and the hydrophilic layer for use in accordance with the present invention in order to get an improved adhesion between these two layers.

A preferred subbing layer for use in connection with the present invention, is a subbing layer which is contiguous to the hydrophilic layer and contains gelatin and silica.

According to the present invention the imaging element comprises on the hydrophilic base a hydrophobic photopolymerizable composition comprising at least one monomer and at least one polymeric binder. When the hydrophilic base comprises a hardened hydrophilic layer, said hydrophobic photopolymerizable composition is preferably contiguous to said hydrophilic base.

The at least one monomer comprised in said photopolymerizable composition can be a monomer having at least one polymerizable ethylenically unsaturated group. Monomers containing at least two polymerizable ethylenically unsaturated groups are preferably used. Particularly preferred are urethane type monomers, such as the compounds of table I and those disclosed in EP-A 502562 and unsaturated esters of polyols, especially esters of polyols and an alpha-methylene carboxylic acid.

Examples of urethane type monomers are given in table I.

**Table I**

1.

$$(CH_2=C-COOCH_2)_2CH-OOCNH-(CH_2)_6-N \quad N-(CH_2)-NHCOO-CH(CH_2OOC-C=CH_2)_2$$
$$CH_3 \qquad\qquad\qquad\qquad\qquad\qquad\qquad\qquad\qquad\qquad\qquad\qquad\qquad\qquad CH_3$$

(with central ring: O=C, C, O=C, C=O, N-(CH_2)-NHCOO-CH(CH_2OOC-C=CH_2)_2, CH_3) 2.

2.

$$C_2H_5-C[CH_2O-CO-NH-(CH_2)_6-NH-COO-CH(CH_2-O-CO-C=CH_2)_2]_3$$
$$CH_3$$

3.

$$C[CH_2O-CO-NH-(CH_2)_6-NH-COO-CH(CH_2-O-CO-C=CH_2)_2]_4$$
$$CH_3$$

4.

$$\text{NHCOO-CH(CH}_2\text{OOC-C=CH}_2)_2$$
$$CH_3$$
$$(CH_2=C-COO-CH_2)_2CH-OOCNH-\langle ring \rangle-CH_2-\langle ring \rangle$$
$$CH_3 \qquad\qquad\qquad\qquad\qquad\qquad\qquad CH_3$$
$$\text{NHCOO-CH(CH}_2\text{OOC-C=CH}_2)_2$$

5.

$$C\left[CH_2O-CO-NH-CH_2-\langle ring \rangle-CH_2-NH-COO-CH(CH_2-O-CO-C=CH_2)_2\right]_4$$
$$CH_3$$

Examples of esters of a polyol and an alpha-methylene carboxylic acid are: ethylene diacrylate, glycerol tri(meth)acrylate, ethylene dimethacrylate, 1,3-propanediol di(meth)acrylate, 1,2,4-butanetriol tri(meth)-acrylate, 1,4-cyclohexanediol di(meth)acrylate, 1,4-benzenediol di(meth)acrylate, pentaerythritol tetra(meth)-acrylate, dipentaerythritol pentaacrylate, 1,5-pentanediol di(meth)acrylate, the bis acrylates and methacrylates of polyethylene glycols of molecular weight 200-500, and the like.

Other types of monomers suitable for use in the photopolymerizable composition in accordance with the present invention are e.g. the monomers disclosed in EP-A 502562, DEOS no. 4,109,239, 4,005,231, 3,643,216, 3,625,203, 3,516,257, 3,516,256 and 3,632,657, which therefor are incorporated herein by reference. Further types of monomers suitable for use in the photopolymerizable composition in accordance with the present invention are disclosed in EP-A 522,616. It will be clear that these monomers can be used in admixture.

In general, the photopolymerizable composition used in accordance with the present invention also comprises at least one photoinitiator, wich can be a single compound or a composition. Preferably used photoinitiators are polymerization initiators activatable by actinic light and inactive at and below the storing conditions of the photosensitive material. Examples of such initiators are disclosed in EP-A 522,616 which therefor is incorporated herein by reference.

A particularly preferred photoinitiator for use in the present invention is a composition comprising a hexaarylbisimidazole, a tetraalkyldiaminobenzophenone e.g. Michler's ketone and a chain transfer agent (also called a hydrogen donor) e.g. 2-mercaptobenzoxazole as disclosed in EP-A 437,259.

An even more preferred photoinitiator for use in the present invention is a composition comprising a triazino-derivate containing at least 2 trihalogenomethyl groups and optionally comprising a sensitizer e.g. Michler's ketone or thioxantone.

According to the present invention thermal polymerization inhibitors may also be added to the photopolymerizable composition. Examples of inhibitors for use in accordance with the present invention are disclosed in EP-A 522,616 wich therefor is incorporated herein by reference.

According to a preferred mode of the present invention the hydrophobic photopolymerizable composition comprising at least one monomer and at least one polymeric binder comprises as polymeric binder a thermoplastic polymer. Suitable thermoplastic polymers for use in accordance with the present invention are disclosed e.g. in EP-A 522,616 which therefor is incorporated herein by reference.

To the hydrophobic photopolymerizable composition there can also be added non-thermoplastic polymeric compounds to give certain desirable characteristics, e.g. to improve adhesion to said hydrophilic base layer used in accordance with the present invention, wear properties, chemical inertness, etc. Suitable non-thermoplastic polymeric compounds include cellulose, phenolic resins and melamine-formaldehyde resins, etc. If desired, the photopolymerizable compositions can also contain immiscible polymeric or non-polymeric organic or inorganic fillers or reinforcing agents which are essentially transparent at the wavelengths used for the exposure of the photopolymeric material, e.g. organophilic silicas, bentonites, silica, powdered glass, colloidal carbon, as well as various types of dyes and pigments in amounts varying with the desired properties of the photopolymerizable composition. The fillers are useful in improving the strength of the composition, reducing tack and in addition, as coloring agents.

Agents to improve the wetting and/or adjust the adhesion of the photopolymerizable composition may be added. Suitable agents are e.g. silicons, silicon containing polymers e.g. a poly(dimethylsiloxane)-polyether copolymer, poly(dimethylsiloxane)-polyester,silicon containing surfactants, fluor containing copolymers and fluor containing surfactants etc..

Various dyes, pigments, thermographic compounds, UV-absorbers, anti-oxidants and color forming components as disclosed in EP-A 522,616 can be added to the photopolymerizable compositions to give a variety of images after the processing . These additive materials, however, preferably should not absorb excessive amounts of light at the exposure wavelength or inhibit the polymerization reaction.

The protective layer may be a transfer layer, which is capable of adhering to the underlying contiguous layer and to a receptor layer, such as a thermo-adhesive layer or a pressure-adhesive layer.

Suitable thermo-adhesive layers (TALs) for use in the present invention have a glas transition temperature $T_g$ between 10 °C and 100 °C as measured with the 1090 THERMOANALYZER of Du Pont Co.. During the lamination and delamination step a minimal thermal load should be imposed to the material in order to save energy and diminish the risk for material change or deformation. For these reasons the $T_g$ of the TAL is preferably below 60 °C. The $T_g$ value of the TAL can be determined by the $T_g$ value of the polymer(s) used and/or by the addition of polymeric or low-molecular plasticizers or thermosolvents.

The adherance of the TAL to the receptor layer is also determined by the flow properties of the TAL while heating above the $T_g$. A parameter for describing this property is the melt viscosity. A TAL for use in accordance with the present invention has a melt viscosity of more than 3000 Poise measured at 120 °C with the VISCOELASTIC MELT TESTER of Rheometrics Co, Surrey, UK..

In order to induce easy film formation without unwanted sticking of the TAL to the backside of the imaging medium or to other materials a TAL is preferably used with a $T_g$ value between 20 °C and 45 °C, a melt viscosity greater than 7000 Poise and an elasticity corresponding to a tg $\delta^{-1}$ value greater than 1.30 measured at 120 °C with the VISCOELASTIC MELT TESTER of Rheometrics Co, Surrey, UK.. The tg $\delta^{-1}$ value is a measure for the elasticity as described in "Polymer Chemistry : the Basic Concept" by P.C. Hiemenz, 1984, edit. by M. Dekker Inc., New York.

For ecological and practical reasons the TAL is preferably coated from an aqueous medium. Therefore the polymers are preferably incorporated as latices.

Preferred latices are latices of styrene, styrene-butadiene, styrene-(meth)acrylate and n.butylacrylate-methylmethacrylate-acrylonitrile. These latices can contain other comonomers which improve the stablitity of the latex, such as acrylic acid, methacrylic acid and acrylamide. Other possible latices include polyvinylacetate, polyethylene-vinylacetate, polyacrylonitrile-butadiene-acrylic acid, polymethylmethacrylate-butylmethacrylate, polymethylmethacrylate-ethylacrylate, polystyrene-butylacrylate, polymethylmethacrylate-butadiene, polyester of terephtalic acid-sulphoisophtalic acid-ethyleneglycol, copolyester of terephtalic acid-sulphoisophtalic acid-hexanediol-ethyleneglycol.

7

Particularly suitable polymers for use in the TAL layer are the BAYSTAL polymer types, marketed by Bayer AG, Germany, which are on the basis of styrene-butadiene copolymers with a weight ratio between 40/60 and 80/20. If desired a few weight % (up to about 10 %) of acrylamide and/or acrylic acid can be included. Other useful polymers are the EUDERM polymers, also from Bayer AG, which are copolymers comprising n.-butylacrylate, methylmethacrylate, acrylonitrile and small amounts of methacrylic acid.

Various additives can be present in the TAL to improve the layer formation or the layer properties, e.g. thickening agents, surfactants, levelling agents, thermal solvents and pigments.

Apart from the thermo-adhesive layer to which the receptor layer will be laminated and which must comply with the requirements described above the material can contain one or more supplementary thermo-adhesive layer(s) positioned between the upper TAL and the hydrophobic photopolymerizable composition e.g. to optimize the adherance to the hydrophobic photopolymerizable composition in view of obtaining a better image quality after the delamination process. This (these) other TAL(s) can have a composition and/or physical properties different from those imposed to the upper TAL. This (these) layer(s) can contain one polymer or a mixture of polymers, optionally in combination with low-molecular additives like plasticizers or thermosolvents. Other ingredients which can be incorporated include waxes, fillers, polymer beads, glass beads, silica etc..

Suitable pressure-adhesive layers (PALs) for use in the present invention comprise one or more pressure sensitive adhesives. Said pressure sensitive adhesives are preferably tacky elastomers e.g. block copolymers of styrene/isoprene, styrene/butadiene rubbers, butyl rubbers, polymers of isobutylene and silicones. Particularly preferred are natural rubbers and acrylate copolymers as disclosed in US-P 3,857,731. The used pressure sensitive adhesive preferably has a continuous-coat (100% coverage) peel adhesion value, when applied to untreated paper, between 1 and 10 N/cm width, more preferably between 2 and 7 N/cm width.

According to the present invention the pressure-adhesive layer comprising a pressure sensitive adhesive may contain a binder. Suitable binders for use in combination with the pressure sensitive adhesives are binders that are inert towards the pressure sensitive adhesives i.e. they do not chemically attack the pressure sensitive adhesives or act as a solvent for them. Examples of such binders are nitrocellulose, urethanes, gelatin, polyvinyl alcohol etc...

The amount of binder should be chosen such that the pressure sensitive adhesives are effectively anchored to the hydrophobic photopolymerizable composition. Preferably the amount of binder is lower than 2.5 parts by weight with respect to the pressure sensitive adhesives and more preferably lower than 0.6.

According to the present invention the pressure-adhesive layer comprising a pressure sensitive adhesive may also contain a tackyfier e.g. rosin soap or a terpene.

According to the present invention the imaging element containing a pressure-adhesive layer comprises preferably also a receptor element on top of said pressure-adhesive layer. In general said receptor element is(are) (a) transparent layer(s) contiguous to said pressure-adhesive layer e.g. a transparent organic resin layer.

The thickness of the transfer layer is important for the adherence during the lamination/delamination process. Preferably the thickness of said transfer layer lies between 0.1 and 30 $\mu$m, more preferably between 0.1 and 15 $\mu$m.

The protective layer according to the invention can also be a receptor layer which is capable of adhering to the underlying contiguous layer and which is upperlying the transfer layer(s) if any is present. Said receptor layer is preferably stable at the processing conditions. The particular layer used is dependant on the nature of the composition of the imaging element. When said receptor layer is the only protective layer in said imaging element, paper or a poly-Alpha-olefin coated paper is used. Otherwise, suitable receptor layers include paper; cardboard; metal sheets; foils and meshes e.g. aluminium, copper, steel, bronze etc.; transparent organic resins e.g. cellulose esters such as cellulose acetate, cellulose propionate and cellulose butyrate, polyvinyl acetals, polystyrene, polycarbonate or polyvinylchloride; opaque foamed or pigmented polyester; silk; cotton and viscose rayon fabrics or screens. Preferred receptor layers are commercially available paper brands as disclosed in PCT/EP 94/02063, which therefor is incorporated herein by reference and films of polyesters such as polyethylene terephthalate or of poly-Alpha-olefins such as polyethylene or polypropylene.

A receptor element according to the invention comprises at least a receptor layer. Said receptor element may further comprises a thin additional layer. Examples of such receptor elements are supports provided with a thin metal layer e.g. polyester supports provided with a vapour deposited metal layer and most useful polyethylene coated paper. A receptor element may also comprise (a) additional layer(s) such as (a) backing layer(s).

In another preferred embodiment, said receptor element comprises as the receptor layer an adhesive layer applied on a flexible support. Suitable adhesive layers and flexible supports are described hereinbefore.

The imaging element may be prepared by coating the layers on each other or by laminating layers or packets of layers to each other.

In a practical embodiment the imaging element is prepared by the following steps:

- coating on a hydrophilic base in accordance with the present invention (i) a hydrophobic photopolymerizable composition comprising at least one monomer and at least one polymeric binder and (ii) a thermo-adhesive layer with optionally an underlying pressure-adhesive layer.

In another practical embodiment the imaging element is prepared by laminating the above described imaging element with its thermo-adhesive layer onto a receptor layer or onto a pressure-adhesive layer coated on a receptor layer.

In still another practical embodiment the imaging element is prepared by the following steps:

- coating on a hydrophilic base in accordance with the present invention a hydrophobic photopolymerizable composition comprising at least one monomer and at least one polymeric binder and
- laminating the above described imaging element with its photopolymerizable composition onto a receptor layer or onto a pressure-adhesive or thermo-adhesive layer coated on a receptor layer.

According to the method of the present invention for obtaining an image an imaging element according to the present invention is image-wise or information-wise exposed to actinic radiation to harden the photopolymerizable composition pattern-wise. The exposure can be a contact exposure using e.g ultraviolet radiation, a camera exposure, a scanning exposure, or a laser exposure. The radiation source used in carrying out the exposure step includes e.g. sunlight, incandescent lamps, mercury vapour lamps, halogen lamps, xenon lamps, fluorescent lamps, light-emitting diodes, lasers, electron rays, and X-rays.

Said exposure can be made through the front side or the back side of the imaging element. It goes without saying that for an exposure through the back the support has to be transparent for the radiation used for the exposure of the photoposensitive imaging element where for a front side exposure any protective layer has to be transparent for said radiation. Preferably the imaging element is exposed through the front side.

Subsequent to the image-wise or information-wise exposure an image is obtained by (i) laminating said imaging element with its upper non-receptor layer to a receptor layer before or after said exposure and (ii) peeling away the receptor element comprising said receptor layer from the hydrophilic base thus transferring said hydrophobic photopolymerizable composition patternwise and the optional upperlying layer(s) to the receptor element and uncovering the image comprised of the hydrophilic base and the retained hydrophobic photopolymerizable composition.

When the imaging element does not comprise a pressure-adhesive layer said laminating is effected by means of a heating step, preferably at a temperature between 40 °C and 180 °C, more preferably at a temperature between 65 °C and 120 °C. Said heating may be applied to either or both the imaging element and the receptor element before, while or after bringing the receptor layer in contact with the upper non-receptor layer of the imaging element. As receptor element different kinds of cheap plain paper can be applied. A broad range of commercial papers with diverging physical properties can be used.

When the imaging element comprises a pressure-adhesive layer, said laminating requires a pressure step. Said pressure is applied while the receptor layer is in contact with the upper non-receptor layer of the imaging element.

An imaging element and a receptor element may be brought in contact before exposure. In such embodiment it is required that either the back of the imaging element and/or preferably the receptor element is transparant for the radiation used for the exposure of the photopolymerizable composition.

An overall exposure, before or after the image-wise exposure can be applied to the imaging element according to the present invention, resulting in a higher sensitivity.

It may be advantageous to overall expose the lithographic printing plate to light and/or heat to enhance its stability. Such a procedure is especially preferred when the imaging element according to the present invention is positive working or to improve the scratch resistance of the lithographic printing plate.

Said lithographic printing plate can further be cleaned with water or an aqueous solution e. g. by wipping with a wet sponge, rinsing with a spray of unheated water or of an aqueous solution etc..

Because the imaging element according to the present invention comprises a hydrophobic photopolymerizable composition on a hydrophilic base, the obtained image can be used as a lithographic printing plate. Pattern-wise transfer of the photopolymerizable composition to a receptor material will then result in an image-wise differentiation between hydrophilic and hydrophobic parts that can be used to print with an oily or greasy ink. The hydrophobic parts will be capable of accepting lithographic ink, whereas the hydrophilic areas, when moistened with water, will not accept the ink. The areas which accept ink form the printing image areas and the ink-rejecting areas form the background areas.

The imaging element can be either positive working or negative working depending i.a. on the weight ratio in the hydrophobic photopolymerizable composition between monomer and (thermoplastic) polymer. For a negative working system said ratio is in general less than 1. For a positive working system said ratio is in general more than 2.

In a negative working imaging element according to the present invention the information-wise exposure to actinic radiation hardens the photopolymerizable composition pattern-wise in correspondence to the information-wise distribution of actinic radiation. Subsequent to the information-wise exposure the image is obtained by (i) laminating said imaging element with its upper non-receptor layer to a receptor layer before or after said exposure and (ii) peeling away the receptor element, comprising said receptor layer from the hydrophilic base, thereby transferring the non-hardened or insufficiently hardened parts of the hydrophobic photopolymerizable composition and the optional upperlying layer(s) to the receptor element and uncovering the image comprised of the hydrophilic base and the retained hardened parts of the hydrophobic photopolymerizable composition together with the underlying parts of the barrier layer.

In a positive working imaging element according to the present invention the information-wise exposure to actinic radiation hardens the photopolymerizable composition pattern-wise in correspondence to the information-wise distribution of actinic radiation. Subsequent to the information-wise exposure the image is obtained by (i) laminating said imaging element with its upper non-receptor layer to a receptor layer before or after said exposure and (ii) peeling away the receptor element, comprising said receptor layer from the hydrophilic base, thereby transferring the hardened parts of the hydrophobic photopolymerizable composition and the optional upperlying layer(s) to the receptor element and uncovering the image comprised of the hydrophilic base and the retained unhardened parts of the hydrophobic photopolymerizable composition together with the underlying parts of the barrier layer.

The following examples illustrate the present invention without limiting it thereto. All percentages are by weight unless stated otherwise.

EXAMPLE 1 ( Comparative example)

Preparation of a hydrophilic base

To 440 g of a dispersion contg. 21.5% of $TiO_2$ (average particle size 0.3 to 0.5 $\mu$m) and 2.5% of polyvinyl alcohol in deionized water were subsequently added, while stirring, 250 g of a 5% polyvinyl alcohol solution in water, 105 g of a hydrolyzed 22% tetramethylorthosilicate emulsion in water and 12 g of a 10% solution of a wetting agent.
To this mixture was added 193 g of deionized water and the pH was adjusted to pH = 4.

The obtained dispersion was coated on a polyethylene-terephthalate film support having a thickness of 175$\mu$m (having provided thereon a hydrophilic adhesion layer) to a wet coating thickness of 50 g/m$^2$, dried at 30 °C. and subsequently hardened by subjecting it to a temperature of 57 °C for 1 week.

Preparation of the imaging elements

A comparative imaging element I was prepared as follows. The hydrophilic base was coated by means of a knife coater with a photosensitive composition consisting of a solution in methylethyl ketone of 1.5 % by weight of dipentaerythritol pentaacrylate, 6.85 % by weight of a copolymer of styrene/butylmethacrylate, 0.15% by weight of a blue dye (C.I. 61551), 1.33 % by weight of bis-imidazole, 0.1% by weight of Michler's ketone, and 0.07% by weight of mercaptobenzoxazole. The mixture was coated to a wet coating thickness of 25 $\mu$m.

An imaging element II according to the invention was prepared similar to the comparitive example I except that the photopolymerizable composition was overcoated by means of a knife coater with a thermo-adhesive composition consisting of a 40% by weight aqueous dispersion of BAYSTAL KA8522, marketed by Bayer AG, Germany, which is a copolymer of styrene/butadiene/acrylic acid with a glas transition temperature $T_g$ of 34 °C (measured with the 1090 THERMOANALYZER of Du Pont Co.), a melt viscosity of more than 13420 Poise and an elasticity corresponding to a tg $\delta^{-1}$ value of 3.54, both last properties measured at 120 °C with the VISCOELASTIC MELT TESTER of Rheometrics Co, Surrey, UK. in a dry thickness of 10 g/m$^2$.

On top of the imaging elements described above there was placed a test target with a 60 lines per cm screen as well as fine positive and negative lines, and the imaging element was exposed therethrough to ultraviolet radiation.

Each of the exposed imaging elements was then placed in face-to-face contact with a paper receptor element (Ideal Blanc Brillant-170 g/m², marketed by Papeterie Belge, S.A., Belgium).

The contacting elements were conveyed through a roll laminator device at 107 °C and at a speed of 0.3 m/min. Immediately thereafter, the elements were peeled apart whereby the non-exposed parts of the photopolymerizable composition are removed and the exposed areas remain on the hydrophilic base thus being a negative working system.

Both samples showed the same sensitivity and a line reproduction for lines of 20 $\mu$m.

The obtained image on the hydrophilic base could be used to print on a conventional offset press using a commonly employed ink and fountain. Good copies were obtained with the sample according to the invention. The quality of the copies obtained with the comparitive sample was inferior to the quality of the copies obtained with the sample according to the invention showing pinholes in the image areas and a number of small staining spots in the non-image areas.

EXAMPLE 2

An imaging element III according to the invention was prepared similar to imaging element II however with 1 % by weight of dipentaerythritol pentaacrylate in the photosensitive composition and a dry thickness of the thermo-adhesive composition of 8 g/m².

The imaging element was then placed in face-to-face contact with a polyethylene-terephthalate film support having a thickness of 63$\mu$m and laminated thereto by conveying them through a roll laminator device at 80 °C and a speed of 0.3 m/min.

On top of the laminated polyethylene-terephthalate film support there was placed a test target with a 60 lines per cm screen as well as fine positive and negative lines, and the imaging element was exposed therethrough to ultraviolet radiation.

The sandwich was again conveyed through a roll laminator device at 85 °C and a speed of 0.4 m/min. Next, the elements were peeled apart whereby the non-exposed parts of the photopolymerizable composition are removed and the exposed areas remain on the hydrophilic base thus being a negative working system.

The sample showed a line reproduction for lines of 30 $\mu$m.

The obtained image on the hydrophilic base could be used to print on a conventional offset press using a commonly employed ink and fountain. Good copies were obtained showing no noticeable pinholes in the image areas or small staining spots in the non-image areas.

EXAMPLE 3

An imaging element IV according to the invention was prepared as follows. The hydrophilic base of example 1 was coated by means of a knife coater with a photosensitive composition consisting of a solution in methylethyl ketone/ethanol (80/20) of 4.7% by weight of compound 1 of table I, 1.96 % by weight of polyvinyl butyral/acetate/alkohol in a weight ratio of 88/9.5/2.5, 0.15 % by weight of a blue dye (C.I. 61551), 1.08 % by weight of bis-imidazole, 0.08 % by weight of Michler's ketone, and 0.06 % by weight of mercaptobenzoxazole. The mixture was coated to a wet coating thickness of 25 $\mu$m.

The photopolymerizable composition was overcoated by means of a knife coater with a thermo-adhesive composition consisting of a aqueous dispersion of 15 % by weight of VINNAPAS:DISPERSION-EV 12, a polyvinyl butyral/acetate/alkohol copolymer marketed by Wacker - Chemie GmbH, Germany and of 10% of polyvinylacetate. The mixture was coated to a wet coating thickness of 40 $\mu$m.

The imaging element was exposed as described in example 1.

The exposed imaging elements was then processed as described in example 1 but at 85 °C and a speed of 1.5 m/min. Next, the elements were peeled apart whereby the exposed parts of the photopolymerizable composition are removed and the non-exposed areas remain on the hydrophilic base thus being a positive working system.

The sample was given an overall exposure to ultraviolet light.

The sample showed a line reproduction for lines of 8 $\mu$m.

The obtained image on the hydrophilic base could be used to print on a conventional offset press using a commonly employed ink and fountain. Good copies were obtained showing no noticeable pinholes in the image areas or small staining spots in the non-image areas.

EXAMPLE 4

The imaging element IV was placed in face-to-face contact with a polyethylene-terephthalate film support having a thickness of 63μm and laminated thereto by conveying them through a roll laminator device at 83 °C and a speed of 1.25 m/min.

The imaging element was exposed as described in example 2.

The exposed imaging elements was then processed as described in example 2 but at 83 °C and a speed of 1.25 m/min. Next, the elements were peeled apart whereby the exposed parts of the photopolymerizable composition are removed and the non-exposed areas remain on the hydrophilic base thus being a positive working system.

The sample showed a line reproduction for lines of 20 μm.

The obtained image on the hydrophilic base could be used to print on a conventional offset press using a commonly employed ink and fountain. Good copies were obtained showing no noticeable pinholes in the image areas or small staining spots in the non-image areas.

EXAMPLE 5

An imaging element V according to the invention was prepared as follows. The hydrophilic base of example 1 was coated by means of a knife coater with a photosensitive composition consisting of a solution in methylethyl ketone of 1.7 % by weight of dipentaerythritol pentaacrylate, 6.67 % by weight of a copolymer of butadiene/acrylonitrile in a weight ratio of 68/32, marketed under the name of HYCAR 1052 by Goodrich, U.S.A., 0.15 % by weight of a blue dye (C.I. 61551), 1.25 % by weight of bis-imidazole, 0.1% by weight of Michler's ketone, and 0.07 % by weight of mercaptobenzoxazole. The mixture was coated to a wet coating thickness of 37.5 μm.

The imaging element was then placed in face-to-face contact with TESA 4122, a pressure-adhesive material with a peel adhesion value of 3.8 N/mm with, marketed by Beiersdorf A.G., Germany and comprising on a polyvinyl chloride support a pressure-adhesive layer of natural rubber.

On top of the pressure-adhesive material there was placed a test target with a 60 lines per cm screen as well as fine positive and negative lines, and the imaging element was exposed therethrough to ultraviolet radiation.

The exposed sandwich was conveyed through a roll laminator at 25 °C and a speed of 0.3 m/min. Next, the elements were peeled apart whereby the non-exposed parts of the photopolymerizable composition are removed and the exposed areas remain on the hydrophilic base thus being a negative working system.

The sample showed a line reproduction for lines of 20 μm.

The obtained image on the hydrophilic base could be used to print on a conventional offset press using a commonly employed ink and fountain. Good copies were obtained showing no noticeable pinholes in the image areas or small staining spots in the non-image areas.

EXAMPLE 6

An imaging element VI according to the invention was prepared similar to imaging element III however with 2.7 % by weight of a 5.5 % by weight of a dispersion of a pigment (C.I. 74160) in methykethylketone instead of the blue dye.

The imaging element was then placed in face-to-face contact with a polyethylene-terephthalate film support having a thickness of 63μm and laminated thereto by conveying them through a roll laminator device at 80 °C and a speed of 0.3 m/min.

On top of the laminated polyethylene-terephthalate film support there was placed a test target with a 60 lines per cm screen as well as fine positive and negative lines, and the imaging element was exposed therethrough to ultraviolet radiation.

The sandwich was again conveyed through a roll laminator device at 85 °C and a speed of 0.4 m/min. Next, the elements were peeled apart whereby the non-exposed parts of the photopolymerizable composition are removed and the exposed areas remain on the hydrophilic base thus being a negative working system.

The sample showed a line reproduction for lines of 30 μm.

The obtained image on the hydrophilic base could be used to print on a conventional offset press using a commonly employed ink and fountain. Good copies were obtained with the sample according to the invention showing no noticeable pinholes in the image areas or small staining spots in the non-image areas.

EXAMPLE 7

Preparation of a hydrophilic base

To 88 g of a dispersion contg. 21.5% of $TiO_2$ (average particle size 0.3 to 0.5 $\mu$m) and 2.5% of polyvinyl alcohol in deionized water were subsequently added, while stirring, 681 g of a 5% polyvinyl alcohol solution in water, 76 g of a hydrolyzed 22% tetramethylorthosilicate emulsion in water and 12 g of a 10% solution of a wetting agent.
To this mixture was added 144 g of deionized water and the pH was adjusted to pH = 4.
The obtained dispersion was coated on a polyethylene-terephthalate film support having a thickness of 175 $\mu$m (having provided thereon a hydrophilic adhesion layer) to a wet coating thickness of 50 g/m², dried at 30 °C. and subsequently hardened by subjecting it to a temperature of 57 °C for 1 week.

Preparation of the imaging elements

An imaging element VII was prepared as follows. The hydrophilic base was coated by means of a knife coater with a photosensitive composition consisting of a solution in methylethyl ketone of 2.0 % by weight of trimethylolpropane triacrylate, 6.35 % by weight of a copolymer of styrene/butylmethacrylate, 0.15% by weight of a blue dye (C.I. 61551), 1.33 % by weight of bis-imidazole, 0.1% by weight of Michler's ketone, and 0.07% by weight of mercaptobenzoxazole. The mixture was coated to a dry thickness of 2.4 $\mu$m.
Said photopolymerizable composition was overcoated by means of a knife coater with a thermoadhesive composition consisting of a 40% by weight aqueous dispersion of BAYSTAL KA8522, marketed by Bayer AG, Germany, which is a copolymer of styrene/butadiene/acrylic acid with a glas transition temperature $T_g$ of 34 °C (measured with the 1090 THERMOANALYZER of Du Pont Co.), a melt viscosity of more than 13420 Poise and an elasticity corresponding to a tg $\delta^{-1}$ value of 3.54, both last properties measured at 120 °C with the VISCOELASTIC MELT TESTER of Rheometrics Co, Surrey, UK. to a dry thickness of 6 g/m².
On top of the imaging elements described above there was placed a test target with a 60 lines per cm screen as well as fine positive and negative lines, and the imaging element was exposed therethrough to ultraviolet radiation.
The exposed imaging element was then placed in face-to-face contact with a subbed polyethylene therephthalate film having a thickness of 100 $\mu$m .
The contacting elements were conveyed through a roll laminator device at 82 °C and at a speed of 0.3 m/min. After cooling to room temperature, the elements were peeled apart at an angle of 180° and a rate of 1 m/min, whereby the non-exposed parts of the photopolymerizable composition are removed and the exposed areas remain on the hydrophilic base thus being a negative working system.
The obtained image showed a line reproduction for lines of 20 $\mu$m.
The obtained image on the hydrophilic base could be used to print on a conventional offset press using a commonly employed ink and fountain. Good copies were obtained showing no noticeable pinholes in the image areas or small staining spots in the non-image areas.

**Claims**

**1.** An imaging element comprising on a hydrophilic base a hydrophobic photopolymerizable composition capable of being irradiated with actinic light through the support and/or through the front and comprising at least one monomer and at least one polymeric binder, characterized in that said imaging element comprises on top of said photopolymerizable composition one or more protective layers selected from the group consisting of:
- a transfer layer which is capable of adhering to the underlying contiguous layer and to a receptor layer, said transfer layer, when being a thermoadhesive layer having a glas transition temperature $T_g$ between 10 °C and 100 °C as measured with the 1090 THERMOANALYZER of Du Pont Co. and a melt viscosity of more than 3000 Poise measured at 120 °C with the VISCOELASTIC MELT TESTER of Rheometrics Co, Surrey, UK.,
- and a receptor layer which is capable of adhering to the underlying contiguous layer and which is upperlying said transfer layer(s) if any is present, said receptor layer, when being the only protective layer in said imaging element being paper or a poly-Alpha-olefin coated paper.

2. An imaging element according to claim 1 wherein said hydrophilic base is a hydrophilic base comprising on a flexible support a hardened hydrophilic layer containing (i) polyvinyl alcohol hardened with hydrolyzed tetraalkyl orthosilicate wherein the weight ratio between said polyvinylalcohol and said tetraalkyl orthosilicate is between 0.1 and 5 and (ii) siliciumoxide and/or titaniumdioxide.

3. An imaging element according to claim 2 wherein said hydrophobic photopolymerizable composition is contiguous to said hydrophilic base.

4. An imaging element according to claim 1 wherein said hydrophilic base is a grained, anodized and optionally sealed aluminum foil.

5. An imaging element according to any of claims 1 to 4 wherein said monomer contains at least two polymerizable ethylenically unsaturated groups.

6. An imaging element according to any of claims 1 to 5 wherein the thickness of said transfer layer lies between 0.1 and 30 $\mu$m.

7. An imaging element according to any of claims 1 to 6 wherein at least one protective layer is a transfer layer belonging to the group of thermo-adhesive layers having a glas transition temperature $T_g$ value between 20 °C and 45 °C, measured with the 1090 THERMOANALYZER of Du Pont Co., a melt viscosity greater than 7000 Poise and an elasticity corresponding to a tg $\delta^{-1}$ value greater than 1.30 measured at 120 °C with the VISCOELASTIC MELT TESTER of Rheometrics Co, Surrey, UK.

8. An imaging element according to any of claims 1 to 5 containing only one transfer layer, the said transfer layer being a pressure-adhesive layer with a continuous-coat (100% coverage) peel adhesion value, when applied to untreated paper between 1 and 10 N/cm width.

9. A method for obtaining a lithographic printing plate comprising the steps of:
   (a) image-wise or information-wise exposing an imaging element according to any of claims 1 to 8
   (b) laminating the upper non-receptor layer of said imaging element to a receptor layer before or after said exposure and
   (c) peeling away the receptor element, comprising said receptor layer from the hydrophilic base thus transferring said hydrophobic photopolymerizable composition pattern-wise to the receptor element.

10. A method for obtaining a lithographic printing plate according to claim 9 wherein the weight ratio in the hydrophobic photopolymerizable composition between said monomer(s) and said polymer(s) is less than 1 so as to form a negative working plate.

11. A method for obtaining a lithographic printing plate according to claim 9 wherein the weight ratio in the hydrophobic photopolymerizable composition between said monomer(s) and said polymer(s) is more than 2 so as to form a positive working plate.

12. A method for obtaining a lithographic printing plate according to claim 9 wherein said imaging element is an imaging element according to any of claims 1 to 7 and wherein heating at a temperature between 25 °C and 180 °C is applied to either or both the imaging element and the receptor element before, while or after bringing both elements in contact with each other or laminating both elements to each other.

13. A method for obtaining a lithographic printing plate according to claim 9 wherein said imaging element is an imaging element according to claim 8 and wherein pressure is applied to both the imaging element and the receptor element while both elements are in contact with each other.

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | GB-A-1 530 410 (FUJI PHOTO FILM CO., LTD.,) | 1-13 | G03F7/34 G03F7/11 |
| D,Y | * the whole document * | 1-13 | |
| Y | US-A-4 925 767 (E.R. DAEMS et Al.) * column 5, line 16 - line 18 * | 1-13 | |
| Y | EP-A-0 465 087 (HOECHST CELANESE CORPORATION) * page 5, line 38 - page 6, line 1 * | 1-13 | |
| D,X | EP-A-0 568 744 (HOECHST CELANESE CORPORATION) * the whole document * | 1-13 | |
| D,X | EP-A-0 450 199 (AGFA-GEVAERT N.V.) * the whole document * | 2 | |
| D,X | EP-A-0 040 424 (DUPONT DE NEMOURS) * the whole document * | 10,11 | |
| A | PATENT ABSTRACTS OF JAPAN vol. 9, no. 90 (P-350) (1813) 19 April 1985 & JP-A-59 218 446 (MITA KOGYO KK) 8 December 1984 * abstract * | 11,12 | TECHNICAL FIELDS SEARCHED (Int.Cl.6) G03F |
| A | US-A-3 060 026 (R.B.HEIART) * column 2, line 53 - line 60 * | 1 | |
| A | US-A-3 342 593 (M.BURG) * column 7, line 62 - line 72; claims * | 12 | |
| A | US-A-3 307 943 (R.B.HEIART) * the whole document * | 1 | |

The present search report has been drawn up for all claims

| Place of search | Date of completion of the search | Examiner |
|---|---|---|
| THE HAGUE | 28 February 1995 | Rasschaert, A |